Europäisches Patentamt

European Patent Office

Office européen des brevets

(11) Veröffentlichungsnummer : **0 042 562**
**B1**

(12) EUROPÄISCHE PATENTSCHRIFT

(45) Veröffentlichungstag der Patentschrift :
05.06.85

(21) Anmeldenummer : 81104570.7

(22) Anmeldetag : 13.06.81

(51) Int. Cl.⁴ : **G 03 C 1/72,** G 03 F 7/26

(54) **Positiv arbeitendes strahlungsempfindliches Gemisch.**

(30) Priorität : 21.06.80 DE 3023201

(43) Veröffentlichungstag der Anmeldung :
30.12.81 Patentblatt 81/52

(45) Bekanntmachung des Hinweises auf die Patenterteilung : 05.06.85 Patentblatt 85/23

(84) Benannte Vertragsstaaten :
**AT BE DE FR GB IT NL SE**

(56) Entgegenhaltungen :
DE-B- 2 610 842
DE-B- 2 718 254

(73) Patentinhaber : **HOECHST AKTIENGESELLSCHAFT**
**Postfach 80 03 20**
**D-6230 Frankfurt am Main 80 (DE)**

(72) Erfinder : **Ruckert, Hans, Dr.**
**Erbsenacker 21**
**D-6200 Wiesbaden-Naurod (DE)**
Erfinder : **Buhr, Gerhard, Dr.**
**Am Erdbeerstein 28**
**D-6240 Königstein (DE)**
Erfinder : **Steppan, Hartmut, Dr.**
**Panoramastrasse 17**
**D-6200 Wiesbaden-Dotzheim (DE)**

## Beschreibung

Die Erfindung betrifft ein positiv arbeitendes, d. h. durch Bestrahlung löslich werdendes strahlungsempfindliches Gemisch, das als wesentliche Bestandteile

a) eine Verbindung mit mindestens einer durch Säure spaltbaren C—O—C-Bindung,
b) eine bei Bestrahlung eine starke Säure bildende Verbindung und
c) ein in Wasser unlösliches, in wäßrig-alkalischen Lösungen lösliches Bindemittel

enthält und zur Herstellung von Druckplatten und Photoresists geeignet ist. Gemische der genannten Zusammensetzung sind z. B. in den US-A 3 779 778, 4 101 323, 4 189 323, den DE-A 27 18 254, 2 928 636 und den EP-A 0 006 626 und 0 006 667 beschrieben.

Obwohl in diesen Druckschriften erwähnt wird, daß außer den alkalilöslichen Bindemitteln noch andere polymere Substanzen zugesetzt werden können, werden in den Ausführungsbeispielen praktisch ausschließlich alkalilösliche Bindemittel, insbesondere Phenolharz-Novolake, beschrieben.

Andere Bindemittel oder Harze sind aber schon als Zusätze für positiv arbeitende strahlungs- oder lichtempfindliche Gemische auf Basis von o-Chinondiaziden bekannt. So wird in der DE-C 16 22 301 der Zusatz von Polyvinylalkyläthern, in der DE-A 22 36 941 der Zusatz von Acrylharzen, in der DE-A 27 33 267 der Zusatz von Terpenharzen und in der DE-A 26 17 088 der Zusatz von Reaktionsprodukten organischer Isocyanate mit Novolaken zu o-Chinondiazidschichten beschrieben, die außerdem alkalilösliche Novolake enthalten können.

Trotz der vielfältigen und teilweise weit zurückliegenden Vorschläge zur Verbesserung und Modifizierung der Eigenschaften von positiv arbeitenden lichtempfindlichen Schichten auf Basis von o-Chinondiaziden für die verschiedensten Anwendungszwecke erfüllen diese Schichten noch immer nicht alle Anforderungen.

Speziell bei den Positivkopierlacken für mikroelektronische Anwendungen, wo es besonders auf hohe Auflösung und exakte Liniendefinition auch nach Temperungsschritten ankommt, haben sich Harzzusätze der genannten Arten nicht durchsetzen können. Auch Polyvinylalkyläther werden trotz zahlreicher Bemühungen in der Mikroelektronik, diese Zusätze enthaltende Resists für die Chip-Herstellung in der Massenproduktion einzuführen, weiterhin nur wenig verwendet. Ein Haupthinderungsgrund ist offenbar, daß in Diazoschichten bei Zusatz dieser Harze in bestimmten Arbeitsschritten unter Produktionsbedingungen auch Nachteile, z. B. Schärfeverlust nach Temperung auftreten können.

Aufgabe der Erfindung war es, positiv arbeitende strahlungsempfindliche Schichten auf Basis der eingangs genannten säurespaltbaren Verbindungen und photolytischen Säurespender in ihren mechanischen und chemischen Eigenschaften so zu modifizieren, daß sie den verschiedensten Anwendungszwecken angepaßt werden können.

Die Erfindung geht aus von einem positiv arbeitenden strahlungsempfindlichen Gemisch aus

a) einer Verbindung mit mindestens einer durch Säure spaltbaren C—O—C-Bindung,
b) einer bei Bestrahlung eine starke Säure bildenden Verbindung,
c) einem in Wasser unlöslichen, in wäßrig-alkalischen Lösungen löslichen Bindemittel und
d) mindestens einem Harz mit anderem Löslichkeitsverhalten als das Bindemittel (c).

Das erfindungsgemäße strahlungsempfindliche Gemisch ist dadurch gekennzeichnet, daß das Harz mit anderem Löslichkeitsverhalten

d1) ein Polyurethanharz aus einem organischen Isocyanat und einem Hydroxygruppen enthaltenden Polymeren,
d2) ein Polyvinylalkyläther,
d3) ein Alkylacrylat-Polymerisat oder
d4) ein hydriertes oder teilhydriertes Kolophonium-Derivat

ist.

Es zeigte sich, daß die Zusatzharze bei den angegebenen Arten von positiv arbeitenden Schichten häufig ganz andere Wirkungen haben als in Schichten auf Basis von Chinondiaziden. Das ergibt sich zum Teil aus den ganz anderen mechanischen Eigenschaften der Grundbestandteile beider Schichttypen. Während üblicherweise die Chinondiazide in Kombination mit Phenolharz-Novolaken die Sprödigkeit der Schicht noch erhöhen, weisen die Orthocarbonsäurederivate, Acetale, Acyliminocarbonate und Enoläther gewöhnlich den gegenteiligen Einfluß auf. Diese Substanzen sind häufig ölige oder niedrigschmelzende Komponenten und tragen daher selbst bereits zur Weichheit, Flexibilität und Verringerung der Sprödigkeit bei.

Während o-Chinondiazid-Novolak-Schichten wegen der kristallinen bis amorphen Eigenschaften der Diazoverbindungen und deren Wechselwirkung mit diesem Harz meist trüb erscheinen, sind die neuen Schichten völlig klar. Reine Chinondiazid-Novolak-Schichten können Haftungsschwierigkeiten auf Silicium-Wafern haben, insbesondere bei dotierten Oberflächen. Das kann spezielle Vorbehandlungsschritte erfordern, wie es z. B. aus den US-A 3 549 368, 3 586 554 und der DE-A 26 17 914 hervorgeht.

So war es überraschend, daß die bereits für Chinondiazidschichten bekannten Harzzusätze mit völlig anderen Effekten in Kombination mit säurespaltbaren Verbindungen wirksam sind. Es war nicht vorherzusehen, daß z. B. ein Polyvinyläthyläther-Zusatz hier die Entwicklungsbreite, d. h. die Differenz zwischen Entwicklungszeit und Entwicklerresistenz, verbessern kann und sogar, im Gegensatz zum Effekt bei Diazoschichten, die Schichteigenschaften beim Tempern begünstigt, d. h. die Fließneigung herabsetzt und die Kantenschärfe vergrößert.

Während belichtete und entwickelte Schichten, die nur aus Novolak, Orthoester-Verbindung und säurebildendem Starter bestehen, trotz guter Haftung auf Silicium-Wafern an unbelichteten Stellen Löcher aufweisen können, deren Ursache noch nicht eindeutig aufgeklärt werden konnte, verschwindet dieser Fehler, wenn die genannten Harze zugesetzt werden. Da die erst beim Entwickeln entstehenden Löcher nicht durch Netzmittel-Zusatz zur Schicht auszuschalten waren, wird angenommen, daß zwischen Polyvinyläthyläther und Novolak-Harz eine die Filmbildung begünstigende Wechselwirkung (Wasserstoffbrücken) eintritt.

Dazu paßt, daß eine Wechselwirkung zwischen säurespaltbarer Verbindung und Novolak-Harz geringer sein dürfte als die bekannte relativ starke Bildung von Addukten oder ähnlichen Aggregaten zwischen o-Naphthochinondiazid und Novolak. Soweit vergleichbar, sind entsprechende Nichtdiazo-Schichten günstiger als Diazoschichten nicht nur bezüglich Entwicklerresistenz, sondern auch bezüglich der Menge an Zusatzharz, die ohne wesentliche Verschlechterung der Kopiereigenschaften zur Verbesserung anderer Eigenschaften der Schicht einverleibt werden kann.

Der Mengenanteil an Zusatzharz, bezogen auf die nichtflüchtigen Bestandteile des Gemischs, liegt je nach Natur des Harzes und der übrigen Schichtbestandteile zwischen 1 und 50 Gew.-%.

Der Zusatzharz-Anteil kann bei Polyvinylalkyläther bei 2 bis 40, bevorzugt 5-25 % liegen. Die günstigste Zusatzmenge liegt bei Polyvinylalkyläthern mit längerkettigen seitenständigen Alkoxyresten, z. B. bei Polyvinylisobutyläther, niedriger als bei Polyvinyläthyläther. Bei Polyvinylmethyläther-Zusatz zu den neuen Schichten fällt überraschend auf, daß nicht nur die Haftung und Weichheit, sondern vor allem elastisch-filmbildende Eigenschaften hervortreten. So werden bei Zusatz von Polyvinylmethyläther zu Positiv-Trockenresistschichten auf Basis säurespaltbarer Verbindungen auch große Bohrlöcher von durchkontaktierten Schaltungen von der Resistschicht überdeckt (Tenting). Je nach säurespaltbarer Substanz und Schichtdicke kann mit gutem Erfolg bis zu 40 % Polyvinylmethyläther in der Schicht enthalten sein. Die maximale Menge ist erreicht, wenn die Entwicklerresistenz sich deutlich verringert oder andere Einflußgrößen, z. B. die Luftfeuchte, das Kopierergebnis in negativer Weise beeinträchtigen.

Ebenfalls anwendungstechnisch gute Ergebnisse werden erzielt bei Zusatz von Polyacrylatharzen, insbesondere Polyäthylacrylaten, die ähnlich Polyvinyläthyläthern die Schicht elastisch und fester machen, ohne die Kopiereigenschaften negativ zu beeinflussen. Als Polyacrylatharze sind bevorzugt die niederen Polyacryl- und -methacrylsäurealkylester zu verstehen, es sind aber auch deren Mischpolymerisate geeignet. Die Acrylatharze verbessern sogar die Entwicklerresistenz, da ihre hochmolekularen Bestandteile die Lösungsgeschwindigkeit unbelichteter Schichtpartien herabsetzen. Ihre Menge kann im allgemeinen 1-20, bevorzugt 5-15 Gew.-% betragen. Bei größeren Mengenanteilen besteht die Gefahr, daß belichtete Schichtteile fladenförmig abgelöst werden, was zu unerwünschten Ablagerungen an anderen Stellen führen kann. Bei der Herstellung von Trockenresistschichten muß dies durch andere Mittel kompensiert werden, was bei den sehr variationsfähigen neuen Positivsystemen auch mittels Wahl der säurespaltbaren Verbindung möglich ist.

Mit Polyacrylat-Harzen kann außerdem in überraschend stärkerem Maße als bei Diazoschichten und stärker als mit den an sich klebrigen Polyvinylalkyläthern die Haftung auf Metalloberflächen verbessert bzw. das Trennverhalten der Positivschichten von Polyester- und Polyolefinfolien gesteuert werden. So ist es möglich, die Adhäsion so zu optimieren, daß solche Gemische als Lösungen auf Polyesterfolien aufgegossen, getrocknet und dann sauber auf Kupfer übertragen (laminiert) werden können. Selbst bei optimierten Diazoschichten gelingt dies nur bei Verwendung speziell vorbehandelter Polyesterfolien, wie es z. B. in der DE-A 24 03 054 beschrieben ist.

Die besten Ergebnisse werden erzielt mit Polyäthylacrylat, niedrigviskos bei 2-12 %, hochviskos bei 1-6 % Zusatz. Allgemein werden die relativ niedermolekularen Polymeren bevorzugt.

Ebenfalls, aber mit geringerem Effekt sind brauchbar Polybutylacrylat, Polybutylmethacrylat und deren Mischpolymerisate. Mischungen von Polyvinylalkyläthern und Polyalkylacrylaten gestatten weitere Feineinstellung der gewünschten Eigenschaften, ohne daß ein negativer synergistischer Effekt auftritt.

Schließlich wurde bei den Versuchen, die neuen lichtempfindlichen Schichten für verschiedene Anwendungen zu verbessern, noch gefunden, daß günstige Effekte auch durch Zusatz von Terpenharzen, Abkömmlingen des Kolophoniums, möglich sind. Die Mengenanteile liegen hier bei etwa 3-50, bevorzugt 7-45 Gew.-%. Solche Harze sind in der Lacktechnik schon lange im Einsatz, da sie auf preiswerten natürlichen Rohstoffen basieren und für zahlreiche Anwendungen vielfältig abgewandelt verfügbar sind.

Für Diazo-Positivschichten wurde schon der Zusatz solcher Harze beschrieben (DE-A 27 33 267). Aus der Vielzahl der als Zusätze für Schichten dieser Art bekannten Harze zeichnen sich in Kombination mit den säurespaltbaren Verbindungen die Harze aus dieser Gruppe sehr günstig im Hinblick auf Beschichtungsqualität, Entwicklerresistenz und Haftung aus, offenbar, weil sie mit den übrigen Schichtbestandteilen, insbesondere den säurespaltbaren Verbindungen auch gut verträglich sind. Auch Harze, die selbst von fester bis brüchiger Konsistenz sind, können die Schichteigenschaften günstig beeinflussen.

Einen Überblick über die verfügbaren Kolophonium-Harze gibt Karsten : Lackrohstoff-Tabellen, Vincentz-Verlag, Hannover. Bevorzugt werden solche Harze, die sich schon für die Herstellung von Druckfarben und Schmelzklebern bewährt haben. Sie können mit den genannten anderen Harzen kombiniert werden.

Bevorzugt werden hydrierte und teilhydrierte Kolophonium-Derivate, insbesondere Terpenharzester, wie Terpenharzmethylester, -glycerinester, -triäthylenglykolester oder -alkydester, da sie oxydationsbeständiger sind. Die günstigsten Kombinationen werden je nach Anwendungszweck im einzelnen durch Versuche ermittelt. So empfehlen sich die Terpenharze weniger für Mikroelektronik-Resists und Galvanoresists, obwohl sie auch dafür verwendbar sind. Sie sind besonders geeignet als Zusätze in Schichten für Produkte wie Trockenresists und Farbfolien, wo nicht oder kaum Temperprozesse der Schicht vorkommen, dafür aber die Flexibilität und Haftung der Schicht von Bedeutung sind.

Schließlich sind als Zusatzharze auch Polyurethanharze geeignet, die durch Umsetzen von organischen Mono- oder Polyisocyanaten mit polymeren Hydroxyverbindungen erhalten werden. Als polymere Hydroxyverbindungen kommen z. B. Polyäther oder Polyester und vorzugsweise Phenolharze, insbesondere Novolake, in Betracht. Die Polyurethane können im allgemeinen in Mengen von 3-30, bevorzugt 5-20 % zugesetzt werden. Dabei ist es möglich und zweckmäßig, zur Umsetzung mit Isocyanat den gleichen Novolak zu verwenden, wie er auch in unmodifizierter Form in der Schicht enthalten ist. Man kann somit in diesem Falle als Harzgemisch ein Reaktionsprodukt aus Novolak und Isocyanat einsetzen, das noch einen größeren Überschuß an nicht umgesetztem Novolak enthält.

Die erfindungsgemäßen lichtempfindlichen Gemische enthalten ferner einen erheblichen Anteil an alkalilöslichem Harz, vorzugsweise Novolak. Die Menge liegt zwischen 20 und 90, vorzugsweise bei 45-80 Gew.-% der Menge der nichtflüchtigen Bestandteile. Die Gesamtmenge an alkalilöslichem Harz und Zusatzharz liegt zwischen 25 und 91, vorzugsweise zwischen 50 und 85 Gew.-%. Die Menge der säurespaltbaren Verbindung beträgt 9-75, vorzugsweise 15-50 %, die Menge des photolytischen Säurespenders 0,1-10, vorzugsweise 0,2-5 %. Diese Bestandteile sind im einzelnen in den obengenannten Druckschriften beschrieben, auf die hier Bezug genommen wird. Mit besonderem Vorteil werden die Orthocarbonsäurederivate, die in der US-A 4 101 323 und der DE-A 29 28 636 beschrieben sind, sowie die Polyacetale, die in der DE-A 27 18 254 beschrieben sind, verwendet.

Die lichtempfindlichen Gemische können auch noch lösliche oder feinteilige dispergierbare Farbstoffe sowie je nach Anwendungszweck auch UV-Absorber enthalten. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Geeignete Lösungsmittel für das erfindungsgemäße Stoffgemisch sind Ketone wie Methyläthylketon ; chlorierte Kohlenwasserstoffe wie Trichloräthylen und 1,1,1-Trichloräthan, Alkohole wie n-Propanol, Äther wie Tetrahydrofuran, Alkoholäther wie Äthylenglykolmonoäthyläther und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Die Wahl der Lösungsmittel ist jedoch auf das vorgesehene Beschichtungsverfahren, die Schichtdicke und die Trocknungsvorrichtung abzustimmen. Dünne Schichten bis ca. 5 μm werden für Versuchsmengen vorzugsweise auf der Schleuder durch Aufgießen aufgetragen. Mit Lösungen bis zu ca. 40 % Feststoffgehalt sind so mit einmaligem Auftrag oder mit einer Streichrakel Schichtdicken von mehr als 60 μm erreichbar. Für beidseitige Beschichtung wird Tauchbeschichtung vorgezogen, wobei durch Verwendung von niedrigsiedenden Lösungsmitteln schnelles Antrocknen erreicht werden kann. Bandbeschichtung erfolgt durch Antragen mittels Walzen, Breitschlitzdüsen oder Sprühen ; Einzelplatten können durch Gießer-Antrag (curtain-coater) beschichtet werden.

Bevorzugte Träger für Schichten von mehr als 10 μm Dicke sind Kunststoffolien, die dann als temporäre Träger für Transferschichten dienen. Dafür und für Farbfolien werden Polyesterfolien, z. B. aus Polyäthylenterephthalat, besonders bevorzugt. Polyolefinfolien wie Polypropylen sind jedoch ebenfalls geeignet. Als Schichtträger für Schichtdicken unter ca. 10 μm werden meist Metalle verwendet. Für Offsetdruckplatten können eingesetzt werden : mechanisch oder elektrochemisch aufgerauhtes und ggf. anodisiertes Aluminium, das zudem noch chemisch, z. B. mit Polyvinylphosphonsäure vorbehandelt sein kann, außerdem Mehrmetallplatten mit Cu/Cr oder Messing/Cr als oberster Schicht. Für Hochdruckplatten können die erfindungsgemäßen Schichten auf Zink- oder Magnesium-Platten für Einstufenätzverfahren aufgetragen werden, zudem auf ätzbare Kunststoffe wie Polyoxymethylen. Für Tiefdruck- oder Siebdruckformen eignen sich die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists beim Formteilätzen einsetzen, wofür eine Vielzahl spezieller Substrate im Handel ist.

Außerdem können Holz, Textilien und Oberflächen vieler Werkstoffe beschichtet werden, die vorteilhaft durch Projektion bebildert werden und resistent gegen die Einwirkung alkalischer Entwickler sind.

Schließlich kann die Beschichtung direkt oder durch trockene Schichtübertragung von einer temporären Trägerfolie erfolgen auf Leiterplatten-Materialien, die aus Isolierplatten mit ein- oder beidseitiger Kupfer-Auflage bestehen, auf Glas oder Keramik-Materialien, die ggf. haftvermittelnd vorbehandelt sind, z. B. mit dünnen Metallschichten auf $Al_2O_3$-Keramikplatten für Streifenleiter in der Mikrowellentechnick.

Die dünnsten Beschichtungen bis unter 1 µm werden für die Mikroelektronik auf Silizium-Wafer aufgebracht, deren Oberflächen Oxid- oder Nitrid-Schichten unterschiedlicher Dicke tragen sowie p- oder n-dotiert sein können. Die erfindungsgemäßen Gemische zeigen speziell in diesem Anwendungsbereich ihre Besonderheiten wie Haftung, Fließbeständigkeit beim Tempern und damit Auflösung, Dimensionsstabilität und Plasmaätzfestigkeit.

Für die Trocknung nach der Beschichtung können die üblichen Geräte und Bedingungen übernommen werden ; Temperaturen um 100 °C und kurzfristig bis 120 °C werden ohne Einbuße an Strahlungsempfindlichkeit vertragen.

Zum Belichten können die üblichen Kopiergeräte wie Röhrenlampen, Xenonimpulslampen, metallhalogeniddotierte Quecksilberdampf-Hochdrucklampen und Kohlebogenlampen verwendet werden. Darüber hinaus ist das Belichten in üblichen Projektions- und Vergrößerungs-Geräten unter dem Licht der Metallfadenlampen und Kontakt-Belichtung mit gewöhnlichen Glühbirnen möglich. Die Belichtung kann auch mit kohärentem Licht eines Lasers erfolgen. Geeignet für die Zwecke vorliegender Erfindung sind leistungsgerechte kurzwellige Laser, beispielsweise Argon-Laser, Krypton-Ionen-Laser, Farbstoff-Laser und Helium-Cadmium-Laser, die zwischen 300 und 600 nm emittieren. Der Laserstrahl wird mittels einer vorgegebenen programmierten Strich- und/oder Raster-Bewegung gesteuert.

Das Bestrahlen mit Elektronenstrahlen ist eine weitere Bebilderungsmöglichkeit. Elektronenstrahlen können das erfindungsgemäße Gemisch wie auch viele andere organische Materialien durchgreifend zersetzen und vernetzen, so daß ein negatives Bild entsteht, wenn die unbestrahlten Teile · durch Lösungsmittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d. h. die bestrahlten Schichtpartien können vom Entwickler entfernt werden.

Die bildmäßig belichtete oder bestrahlte Schicht kann mit den gleichen Entwicklern wie für die bekannten Schichten auf Basis säurespaltbarer Verbindungen entfernt werden, bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Im folgenden werden Beispiele für die erfindungsgemäßen lichtempfindlichen Gemische angegeben. Die Prozent- und Mengenverhältnisse sind, wenn nichts anderes angegeben ist, in Gewichtseinheiten zu verstehen. Gewichtsteile (Gt) und Volumteile (Vt) stehen im Verhältnis von g/ccm.

## Beispiel 1

Zur Herstellung mikroelektronischer Schaltelemente hoher Packungsdichte wurde eine käufliche, wie üblich polierte und durch Oxydation mit einer 0,2 µm dicken $SiO_2$-Schicht versehenen Siliciumscheibe mit folgendem Positiv-Kopierlack beschichtet.

In 70 Gt eines Lösungsmittelgemisches aus Äthylenglykoläthylätheracetat, Butylacetat und Xylol 8 : 1 : 1 wurden.

18 Gt eines Kresol-Formaldehyd-Novolaks mit dem Erweichungsbereich 105-120 °C nach DIN 53181,
9,5 Gt Triäthylenglykol-bis-diphenoxymethyläther,
1,2 Gt 2-(4-Äthoxy-naphth-1-yl)-4,6-bis-trichlormethyl-s-triazin und
1,3 Gt Polyäthylacrylat niedrigviskos (Plexisol® B 574)

gelöst und durch einen 0,5 µm Filter filtriert.

Beim Schleuderbeschichten des Trägers wurde bei 9 000 U/min eine Resistschicht von ungefähr 1,2 µm Dicke erhalten, die noch 10 Minuten bei 90 °C im Umluftschrank getrocknet wurde. Nach dem Abkühlen und Konditionieren auf ein definiertes Raumklima von 23 °C und 40-50 % relativer Feuchte wurde in einem Wafer-Kontaktbelichtungsgerät unter einer handelsüblichen Chrommaske mit hochaufgelösten Testfeldern mit einer 200 Watt Hg-Hochdrucklampe etwa 1 Sekunde belichtet.

Entwickelt wurde bei 25 °C in einem bewegten Entwickler, bestehend aus

2,67 % Natriummetasilikat × 9 Wasser,
1,71 % Trinatriumphosphat × 12 Wasser,
0,17 % Mononatriumphosphat, gelöst in
95,45 % vollentsalztem Wasser.

Anschließend wurde mit vollentsalztem Wasser gespült und mit Stickstoff trocken geblasen.

Durch die filmbildenden Eigenschaften des Zusatzharzes wurde die Haftung und Ätzfestigkeit bei der Ätzung mit NH₄F-gepufferter Fluorwasserstoffsäure merklich verbessert. Diese Eigenschaft konnte durch Erhöhen des Zusatzharz-Anteils bis auf etwa die doppelte Menge noch verstärkt werden. Wenn dabei je nach Schichtdicke, Trocknung und Belichtung eine Schleiereignung auftrat, konnte diese durch Erhöhen der Konzentration des Entwicklers ohne Beeinträchtigung des durch die erhöhte Harzmenge erreichten Effektes beseitigt werden.

Ähnliche Ergebnisse wurden erhalten, wenn anstelle des verwendeten aromatisch-aliphatischen Orthoesters die gleiche Menge des aliphatischen Orthoesters Bis-(2,5-diäthyl-5-butyl-1,3-dioxan-2-yl)-äther des Triäthylenglykols verwendet wurde.

## Beispiel 2

Eine Positiv-Trockenresistschicht von 50 μm Dicke wurde auf eine 25 μm dicke Polyesterfolie, die mit Trichloressigsäure/Polyvinylalkohol vorbehandelt worden war, aufgebracht und mit einer Polyäthylen-Deckfolie kaschiert. Die Trockenresistschicht wurde durch Beschichten mit folgender Lösung hergestellt :

34,5 Gt Äthylenglykolmonomethyläther,
21,0 Gt Methyläthylketon,
27,5 Gt Novolak wie in Beispiel 1,
5,4 Gt Polyglykol 2000,
9,7 Gt des Polyacetals aus 2-Äthyl-butyraldehyd und Triäthylenglykol,
0,3 Gt 2-[4-(2-Äthoxy-äthoxy)-naphth-1-yl]-4,6-bis-trichlormethyl-s-triazin,
1,9 Gt handelsübliches Lackhilfsmittel auf Silikonbasis und
0,02 Gt Kristallviolett-Base.

Durch Laminieren unter Druck und Wärme in einem handelsüblichen Laminator für die Leiterplattenfertigung wurde eine kupferkaschierte Isolierstoffplatte nach Abziehen der Deckfolie mit dieser Trockenresistschicht beschichtet. Nach dem Abziehen der Trägerfolie von dem beschichteten und inzwischen abgekühlten Leiterplattenmaterial wurde 50 Sekunden im Abstand 140 cm mit einer 5 kW Metallhalogenidlampe unter einer entsprechenden Vorlage belichtet. Es kann auch durch die Trägerfolie belichtet werden. Vorzugsweise wird aber die Trockenresistschicht in direktem Kontakt mit der Vorlage und nach einer Nachtrocknung, z. B. 10 Minuten bei 80 °C, belichtet. Anschließend wurde in einem Sprühgerät mit folgender Entwicklerlösung entwickelt :

0,6 % NaOH,
0,5 % Natriummetasilikat × 5 Wasser,
1,0 % n-Butanol,
97,9 % vollentsalztes Wasser.

Durch stufenweisen Ersatz des Polyglykols durch Polyäthylacrylat kann die Weichheit der Schicht nach Belieben verringert eingestellt und Entwicklerresistenz sowie die Qualität als Galvanoresist verbessert werden. Wenn bei der Beschichtung nicht sehr stark getrocknet wird, kann als Trägerfolie Polyester ohne die genannte Vorbehandlung verwendet werden.

## Beispiel 3

Aus Äthylenglykolmonomethyläther wurde auf die in Beispiel 2 genannte Trägerfolie eine 25 μm dicke Positiv-Trockenresistschicht aufgetragen, die aus

65,0 % Novolak wie in Beispiel 1,
19,5 % eines Polyorthoesters, hergestellt durch Polykondensation von Orthoameisensäuretrimethylester mit 2-Äthyl-2-hydroxymethyl-4-oxa-octan-1,8-diol ; mittleres Molgewicht 1470,
0,7 % des in Beispiel 1 angegebenen Triazinderivats,
0,06 % Kristallviolett-Base,
5,9 % Vinylacetat-Crotonsäure-Mischpolymerisat (95 : 5) und
5,9 % Polyester aus Adipinsäure und 1,2-Propandiol

bestand.

Für die Herstellung durchkontaktierter Leiterplatten wurde dieser Trockenresist auf handelsübliches, beidseitig kupfer-kaschiertes Basismaterial, das je nach Schaltung mit Bohrungen bis 2 mm Durchmesser versehen war, auflaminiert. Anschließend wurde die Trägerfolie abgezogen, die Schicht kurz nachgetrocknet und wie in Beispiel 1 belichtet und entwickelt. In diesem Fall wurde die beidseitig beschichtete Platte auch beidseitig belichtet und durch Ansprühen von beiden Seiten in einer entsprechenden Sprühentwicklungsmaschine gleichzeitig entwickelt.

Ohne Zusatz des Mischpolymerisats und des Weichmachers waren die Filmeigenschaften des Resists zu schwach. Die Beständigkeit der Resisthaut über den Bohrlöchern war beim Sprühentwickeln mit diesen Zusätzen schon bei Löchern von 0,5 mm Durchmesser gut. Wenn dieses Harz und der Weichmacher stufenweise oder völlig durch das weichmachende Harz Polyvinylmethyläther (Lutonal® M 40) ersetzt wurden, so wurden Positiv-Trockenresists erhalten, die in hervorragender Weise geeignet waren, Bohrlöcher bis zu 2 mm Durchmesser abzudecken.

Bei Erhöhung des Polyvinylmethyläther-Anteils auf 20 % und gleichzeitiger Reduzierung des Novolak-Gehalts der Schicht auf 60 % konnten auch mit 15 μm dicken Positiv-Trockenresists Bohrlöcher von 1 mm Durchmesser sicher sprühentwickelt werden, ohne daß der Resistfilm aufriß.

Ähnliche Ergebnisse wurden mit dem polymeren Orthoester aus Orthoameisensäuretrimethylester und 2-Äthyl-2-hydroxymethyl-5-methyl-4-oxa-heptan-1,7-diol erhalten.

## Beispiel 4

Ein Positiv-Kopierlack wurde wie in Beispiel 1 zum Aufbringen feiner Schaltungsmuster auf Silicium-Wafer verwendet.

76 Gt Lösungsmittelgemisch wie in Beispiel 1,
13,6 Gt Novolak wie in Beispiel 1,
6,6 Gt 1,3-Bis-[2-(5-äthyl-5-butyl-1,3-dioxacyclohexoxy)]-2-äthyl-2-butyl-propan,
1,1 Gt des in Beispiel 2 angegebenen Triazins,
2,7 Gt Polyvinyläthyläther (Lutonal® A 25).

Nach Aufschleudern dieser Lösung mit 6 000 U/min und Nachtrocknen im Umlufttrockenschrank wurde ein lagerfähiger, positiv vorsensibilisierter Wafer von mehrfach höherer Lichtempfindlichkeit, verglichen mit handelsüblichen Positiv-Kopierlackschichten gleicher Dicke auf o-Naphthochinondiazid-Basis, erhalten. Beim Vergleich mit dem für die Mikroelektronik viel verwendeten Photoresist AZ 1350 J® auf Basis von o-Chinondiaziden wurden beim Kopieren wie in Beispiel 1, jedoch unter Zwischenschaltung eines die Belichtungszeiten verlängernden Filters, für die Nichtdiazo-Schicht 3 Sekunden gebraucht, für die Diazo-Schicht 20 Sekunden. Beide Belichtungszeiten sind jeweils optimiert auf gute Auflösung bis ca. Feld 3/2 der ITEK-Testvorlage bei 1 Minute Entwicklung in der in Beispiel 1 angegebenen Entwicklerlösung.

Von beiden Schichten wurde auch das Plasmaätzverhalten untersucht, jeweils 30 Minuten bei 120 °C ohne und mit Tempern der kopierten Wafer. Beim Plasmaätzen bis zur maximalen Temperatur von 230 °C, wobei in 10 Minuten 80 nm $SiO_2$ weggeätzt wurden, waren die getemperten Prüfmuster fast gleich. Die nicht getemperten zeigten unter diesen Bedingungen merklichen Lackangriff und entsprechende Verbreiterung der geätzten Linien.

Wenn in der vorstehenden Beschichtungslösung der Polyvinyläthyläther weggelassen und bei niedrigerer Schleudergeschwindigkeit eine Schicht gleicher Dicke auf dem Wafer hergestellt wurde, so kam man zu schlechteren Kopiereigenschaften, da die Schicht inhomogener war und die Kanten teilweise aufgerissen aussahen. Beim Tempern wurde das Schichtprofil dieser Vergleichsschicht durch Verformen weiter verschlechtert und beim Plasmaätzen das schlechteste Ergebnis erhalten. Insgesamt am besten bezüglich Plasmaätzbarkeit, Auflösung und Lichtempfindlichkeit war die in diesem Beispiel beschriebene Schicht.

## Beispiel 5

Zur Herstellung von Positiv-Kopierlacken für die Herstellung von autotypischen Kupfer-Tiefdruckzylindern wurden in einem Gemisch von 1,1,1-Trichloräthan, n-Butylacetat und Äthylenglykolmonoäthyläractetat (5 : 3 : 2) zu Lösungen von jeweils insgesamt 100 Gt unter Rühren gelöst:

10 Gt Novolak wie in Beispiel 1,
3 Gt 1,8-Bis-(3,4-dihydro-naphth-2-yloxy)-3,6-dioxa-octan,
0,25 Gt 2-(Acenaphth-5-yl)-4,6-bis-trichlormethyl-s-triazin,
0,1 Gt Kristallviolett-Base

und entweder

1) 2 Gt mit Pentaerythrit verestertes Kolophonium-Harz (Resin B-106®) oder
2) 5 Gt Glycerinester von teilweise hydriertem Wurzelharz (Staybelite® Ester 5) oder
3) 4 Gt Glycerinester von teilweise hydriertem Kolophonium (Staybelite® Ester 610) (alle Produkte von Hercules Inc.).

Mit den drei mit Zusatzharz 1, 2 oder 3 versehenen Kopierlacken und einer Vergleichslösung ohne Zusatzharz wurde mittels einer Spritzpistole je ein Viertel eines frisch verkupferten rotierenden Kupferzylinders ca. 3 μm dick beschichtet und mittels Warmluft oder Infrarot-Strahlern getrocknet. Anschließend wurde unter einem gerasterten Negativ des zu druckenden Motivs belichtet und durch Aufgießen von 0,8 %iger Natronlauge auf den langsam rotierenden Zylinder die Kupferoberfläche bildmäßig freigelegt, was bei diesen Schichten innerhalb 2-4 Minuten abgeschlossen war. Anschließend wurde mit Wasser abgespült und durch weiteres Rotieren in warmer Luft der Zylinder getrocknet.

Vor der üblichen Tiefdruckätzung mit Ferrichlorid-Lösung wurden an den zu vergleichenden vier Schichtpartien Retuschen angebracht, indem mechanisch mittels eines Stichels korrigiert, Markierungen und zusätzliche Linien angebracht wurden. Dies gelang am einfachsten und saubersten, d. h. mit den glattesten Kanten und ohne feine Ausplatzungen der Ätzreservagen mit der 3. Schichtvariante, es folgten Schicht 1 und 2. Die Vergleichsschicht war relativ am sprödesten und zeigte nach der Ätzung die stärkste Unterätzung der Tiefdruckstege.

Beispiel 6

In diesem Beispiel wird die Verbesserung der Oleophilie und Entwicklerresistenz einer Offset-Druckform gezeigt.

Auf einseitig drahtgebürstetes Aluminium wurde eine Beschichtungslösung aus

7 Gt eines modifizierten Phenol-Formaldehyd-Novolaks (hergestellt aus 140 Gt Novolak und 6,5 Gt des Additionsprodukts aus 3 Mol Tolylendiisocyanat und 1 Mol Trimethylolpropan),
2 Gt 2-(Naphth-2-yloxy)-5,5-dimethyl-1,3-oxazolin-4-on,
0,4 Gt 2-(4-Methoxy-anthrac-1-yl)-4,6-bis-trichlormethyl-s-triazin und
0,1 Gt 4-Diäthylamino-azobenzol in
90,8 Gt eines Lösungsmittelgemischs aus Tetrahydrofuran, Äthylenglykolmonomethyläther und Butylacetat (5 : 4 : 1)

aufgebracht.

Die Dicke der erhaltenen Schicht entsprach einem Schichtgewicht von 2 g/cm$^2$.

Nach dem Trocknen wurde unter einer positiven Vorlage belichtet, mit einer 3,5 %igen wäßrigen Lösung von Trinatriumphosphat entwickelt, die durch Zugabe von Natriumhydroxid auf ein pH von 12,6 eingestellt war, dann mit Wasser abgespült und schließlich durch Überwischen mit 1 %iger Phosphorsäure druckfertig gemacht. Selbst wenn man die Platte bis zum 12-fachen der ausreichenden Entwicklungszeit in der Entwicklerlösung liegen ließ, entstanden praktisch keine Schäden an den Bildstellen. Anschließend wurde eine solche Platte zum Drucken verwendet und zeigte sehr schnelle Annahme der Druckfarbe, besser als bei Verwendung einer entsprechenden Druckplatte mit ausschließlich unmodifiziertem Phenol-Formaldehyd-Novolak. Ebenfalls besser war die Qualität der Druckplattenoberfläche nach Einbrennen der Druckform bei 230 °C. Ähnliche Ergebnisse wurden erhalten, wenn anstelle des angegebenen modifizierten Harzes 6 Gt des Kondensationsprodukts aus 5 Gt Octadecylisocyanat und 100 Gt des gleichen Novolaks verwendet wurden.

Beispiel 7

In diesem Beispiel wird beschrieben, wie galvanoplastisch eine Nickel-Rotationsschablone für den Textil- und Tapetendruck hergestellt wird.

Auf einen blanken, etwas kontrahierbaren Nickelzylinder, der mit einer leitenden Trennschicht versehen war, wurde durch 3-maliges Sprühbeschichten mit Zwischentrockung eine ca. 25 μm dicke Schicht folgender Zusammensetzung aufgebracht :

35 % Novolak,
25 % des Kondensationsprodukts aus 187 Gt Phenol-Formaldehyd-Novolak und 6,5 Gt des in Beispiel 6 angegebenen Isocyanat-Additionsprodukts,
15 % Polyvinylmethyläther (Lutonal® M 40),
24 % N-Diphenoxymethyl-ε-amino-caprolactam,
1 % des in Beispiel 5 angegebenen Triazins,
0,1 % Kristallviolett-Base.

Unter einem Positiv des zu druckenden Motivs, dessen Tonwertabstufungen mit einem 32-er Raster wie üblich in Bildpartien unterschiedlicher Flächendeckung umgesetzt waren, wurde ausreichend belichtet. Für eine Positivschicht der halben Dicke auf Basis von Naphthochinondiaziden war die 5-fache Belichtungszeit nötig. Entwickelt wurde mit einer Lösung von

0,5 % Natronlauge,
0,8 % Natriummetasilikat $\times$ 9 $H_2O$,
1,0 % Äthylenglykolmono-n-butyläther in
97,7 % vollentsalztem Wasser.

Dies geschah durch Eintauchen des rotierenden belichteten Zylinders in eine mit dem Entwickler halbgefüllte Wanne entsprechender größe. Die Entwicklerresistenz der Schicht war sehr gut und ermöglichte steile Flanken der Resistkanten. Nach ca. 6 Minuten Rotieren des Zylinders im Entwickler wurde die Entwicklerwanne weggezogen und der Zylinder mit Wasser gespült und an der Luft getrocknet.

Da der verwendete Resist im Vergleich zu Diazoschichten nicht nur relativ dick, sondern auch gut haftend, elastisch und nicht brüchig war, konnte die Passernaht, die durch das Aneinanderstoßen oder Überlappen des Films beim Belichten des Rundzylinders entsteht, mechanisch mit einem Stichel oder feinen Bohrer vergleichsweise leicht sicher und daher wesentlich schneller retuschiert werden.

Durch galvanische Nickelabscheidung bis ca. 0,1 mm Dicke, Kontrahieren des Zylinderkernes, Strippen des Resists mit Aceton oder 5-10 %iger Natronlauge sowie Abziehen vom Kern wurde eine elastische Rotations-Druckform erhalten. Durch die konisch etwas verengten Löcher konnte Farbe bildmäßig auf Bedruckstoffe übertragen werden. Wegen der hiermit möglichen dickeren Schichten konnten kleinere Löcher, d. h. hellere Bildpunkte besser vor dem Zuwachsen geschützt und damit der Tonwertumfang erweitert werden.

Ein ähnliches Ergebnis bezüglich Haftung und mechanischer Eigenschaften dicker Schichten wurde erzielt, wenn anstelle des Polyvinylmethyläthers etwa der gleiche Prozentsatz von hydriertem Methylester von Kolophonium verwendet wurde. Die Entwicklung dauerte dann ca. 1/3 länger, was durch Anwenden eines etwas höher konzentrierten Entwicklers ausgeglichen werden konnte. Anstelle des säurespaltbaren Amidacetals kann auch das 1,2,6-Tris-(3,4-dihydro-naphth-1-yloxy) hexan eingesetzt werden.

### Beispiel 8

Eine Aluminiumplatte aus elektrolytisch aufgerauhtem, anodisiertem und mit Polyvinylphosphonsäure vorbehandeltem Aluminium wurde mit einer 2,2 $\mu$m dicken Schicht aus

2 Gt Novolak wie in Beispiel 1,
0,4 Gt des polymeren Orthoesters aus Orthoameisensäuretrimethylester und 2-Methyl-2-hydroxymethyl-4-oxa-octan-diol, MG 2580,
0,13 Gt 2-[4-(2-Äthoxy-äthoxy)-naphth-1-yl]-4,6-bis-trichlormethyl-s-triazin,
0,007 Gt Kristallviolett-Base,
0,2 Gt Polybutylacrylat (Plexisol® D 592)

versehen.

Diese Schicht wurde in einem Laserbestrahlungsgerät (Laserite® 150 R der Fa. Eocom Corp.) mit einem Argonionen-Laser mit 10 mJ/cm² bildmäßig bestrahlt. Die belichteten Schichtteile wurden innerhalb 2 Minuten mit einem Entwickler aus

5,5 Gt Natriummetasilikat $\times$ 9 Wasser,
3,4 Gt Trinatriumphosphat $\times$ 12 Wasser,
0,4 Gt Mononatriumphosphat (wasserfrei),
90,7 Gt vollentsalztem Wasser

entfernt.

Durch Einfärben der unbestrahlten Bereiche mit fetter Farbe ließ sich das Bild noch deutlicher hervorheben.

Wurde die Druckplatte direkt verglichen mit einer sonst gleichen Druckplatte, die kein Polybutylacrylat enthielt, so ergaben sich folgende Unterschiede. Das Zusatzharz verlangsamt zwar etwas die Entwicklungsgeschwindigkeit, verbessert aber die Beschichtungsqualität und Farbannahme. Der Hauptvorteil war die Erhöhung der erreichbaren Druckauflage um mehr als die Hälfte, wodurch eine mit Laser bebilderbare hochempfindliche Druckplatte für den Auflagenbereich über 100 000 zugänglich wird. Ähnliche Ergebnisse wurden erhalten, wenn als säurespaltbare Verbindung das Polykondensationsprodukt aus Orthoameisensäuretrimethylester und 1,2,6-Hexantriol verwendet wurde. Ohne wesentliche Änderung der erreichten Vorteile konnte das Zusatzharz bis zur Hälfte seiner Menge durch ein Mischpolymerisat auf Basis von Butylmethacrylat und Methylmethacrylat (Plexisol® PM 709) oder durch einen niedrigviskosen Polyisobutylvinyläther (Lutonal® I 60) ersetzt werden.

### Beispiel 9

Zur Herstellung eines Positiv-Trockenresists für Ätz- und Galvanoreservagen wurde die folgende Lösung hergestellt :

57 Gt Methyläthylketon,
20 Gt Novolak wie in Beispiel 1,
10 Gt des in Beispiel 7 angegebenen modifizierten Novolaks,
4,5 Gt Bis-(5-äthyl-5-methoxymethyl-1,3-dioxan-2-yl) äther von 2-Äthyl-2-methoxymethyl-1,3-propandiol,
4,0 Gt 1,3-Propandiol-bis-(3,4-dihydro-naphth-2-yl) äther,
0,2 Gt des in Beispiel 2 angegebenen Triazins,
0,05 Gt Kristallviolett-Base,
4,2 Gt eines Polyurethans aus Diisocyanat und aromatischem Polyester (Estane® 5715 der Goodrich Co.).

Damit wurde eine biaxial verstreckte und thermofixierte 25 μm dicke Folie aus Polyäthylenterephthalat so beschichtet, getrocknet und mit einer 12 μm dicken Polypropylen-Deckfolie kaschiert, daß eine gleichmäßig dicke Resistschicht zwischen den beiden Folien enstand.

In einem handelsüblichen Laminator wurden nach Abziehen der Deckfolien blanke Messingplatten zur Herstellung von Kontaktfedern für Schalter beidseitig mit diesem Resist unter Druck und Wärme beschichtet. Nach Abkühlen, Abziehen der Trägerfolien, kurzem Nachtrocknen im Trockenschrank (80 °C) wurde mit einem deckungsgleichen Vorlagenpaar in Form einer Tasche das beschichtete Werkstück beidseitig ausreichend belichtet. Anschließend wurd mit dem in Beispiel 2 genannten Entwickler beidseitig sprühentwickelt und nach Abspülen der alkalischen Entwicklerreste wurden die nassen Platten mit handelsüblicher Ferrichlorid-Lösung beidseitig so lange geätzt, bis sie zu glatten Flanken durchgeätzt waren.

Die so im Nutzen hergestellten Formätzteile wurden vor dem Vereinzeln zum Freilegen und Vergolden der Kontaktenden mit der entsprechenden Vorlage belichtet, entwickelt und schließlich an den freigelegten Stellen dünn galvanisch vergoldet. Anschließend wurden diese Schalterteile in die richtige Form gebogen und eingebaut. Wegen der guten Haftung und Flexibilität dieser Schicht, insbesondere infolge der zugesetzten gut verträglichen beiden Polyurethanharze, konnte der Resist auch nach und evtl. bei Wärmeeinwirkung als Isolations- und Schutzschicht auf diesen Kontaktfedern verbleiben. Ohne diese Zusätze sprang der Resist nach einiger Zeit federnder Beanspruchung stückchenweise ab. Darüber hinaus wurde die Trennbarkeit von der Polyester-Trägerfolie nach dem Laminieren soweit verbessert, daß auf die hydrophile Vorbehandlung der Polyesterfolie verzichtet werden konnte.

Beispiel 10

Auf einen oxydierten Silicium-Wafer wurde eine 0,7 μm dicke Schicht folgender Zusammensetzung aufgeschleudert :

52 Gt Novolak wie in Beispiel 1,
21 Gt des Kondensationsprodukts aus 144 Gt Phenol-Formaldehyd-Novolak und 4,6 Gt Tris-(4-isocyanato-phenyl) ester der Thionophosphorsäure.
27 Gt des polymeren Orthoesters aus Orthoameisensäuretrimethylester und 2-Chlormethyl-2-hydroxymethyl-4-oxa-1,8-octandiol.

Die Bebilderung kann mit Elektronenstrahlen erfolgen, ohne daß ein Starter zugesetzt werden muß, da der säurespaltbare Polyorthoester selbst abspaltbares Chlor in einer Chlormethylgruppe enthält. Diese Harzkombination bewirkt gleichzeitig hohe Auflösung und thermische Beständigkeit (Dimensionsstabilität).

Die Bebilderung erfolgte durch Bestrahlen mit 11 keV-Elektronen bei einer Energie von ca. $3 \times 10^{-2}$ J/cm².

Nach 60 Sekunden Entwickeln mit der Entwicklerlösung von Beispiel 1 konnten die bestrahlten Schichtpartien entfernt werden. Diese Schicht zeigte sowohl bei der Plasma- als auch Flußsäure-Ätzung weniger seitlichen Schichtangriff als ein entsprechender Resist, der keinen modifizierten Novolak, aber 73 Teile Novolak enthielt. Für Hochtemperatur-Plasmaätzungen wurden beide Schichten gleichzeitig 30 Minuten bei 120 °C getempert, wobei sich die Flanken des oben beschriebenen hochauflösenden Elektronenstrahl-Resists deutlich weniger abflachten.

Wurde mit einer Energie von mindestens 0,5 Joule/cm² bestrahlt, so wurden die organischen Resistmaterialien durchgreifend zersetzt und vernetzt. Es entstand ein negatives Bild, wenn die unbestrahlten Teile durch Lösungsmittel oder Belichten ohne Vorlage und Entwickeln mit dem Entwickler von Beispiel 1 entfernt wurden.

Beispiel 11

Es wurden hochlichtempfindliche Positiv-Farbfolien z. B. für die Montagekontrolle im Mehrfarben-Offsetdruck hergestellt. Die Kopierschichten hatten folgende Zusammensetzung :

47 Gt Novolak wie in Beispiel 1,
38 Gt Kolophonium-Derivat vom Alkydharz-Typ, (Neolyn® 20 der Hercules Inc.),
13 Gt 2,2-Bis-(4-diphenoxymethoxy-phenyl)-propan,
0,5 Gt 2,5-Diäthoxy-4-(p-tolylthio)-benzodiazonium-hexafluorophosphat,
1,5 Gt Zaponechtblau HFL (C. I. 2880) oder
1,2 Gt Zaponechtrot BB (C. I. 2864) oder
2,0 Gt Fettgelb 5 G (C. I. Suppl. 572).

Die Schichtdicken zwischen 1 und 3 µm und die Farbstoffmengen wurden so aufeinander abgestimmt, daß die Rot-, Blau- und Gelb-Farbfolie die gleiche Lichtempfindlichkeit aufwiesen, d. h. bei sowohl gleicher Belichtungs- als auch Entwicklungszeit mit einem wäßrig-alkalischen Entwickler gleich lange Keilstufen bei einem mitkopierten Halbton-Testkeil ergeben. Diese Farbfolien sind deutlich kratzfester und klebebandbeständiger als vergleichsweise hergestellte Farbfolien ohne Zusatz an modifiziertem Terpenharz.

## Beispiel 12

Es wurde eine 70 µm dicke Positiv-Trockenresistschicht folgender Zusammensetzung auf eine 25 µm dicke Polyesterfolie beschichtet und mit einer Polyäthylen-Deckfolie kaschiert.

61 Gt Novolak (1 : 1-Gemisch des Novolaks von Beispiel 1 mit Phenol-Formaldehyd-Novolak mit dem Schmelzbereich 110-120 °C),
10 Gt Polybutylacrylat wie in Beispiel 8,
6 Gt Polyurethan aus Diisocyanat und aromatischem Polyester (Estane® 5702 von Goodrich),
22,7 Gt des Polyacetals aus Benzaldehyd und 1,5-Pentandiol,
0,3 Gt 2-(5-Methyl-6-methoxy-naphth-2-yl)-4,6-bis-trichlormethyl-s-triazin und
0,05 Gt Kristallviolett-Base.

Damit wurde wie üblich Leiterplattenmaterial aus kupferkaschiertem Isoliermaterial in einem Laminator beschichtet und unter einer entsprechenden Vorlage kopiert. Im Vergleich zu einem auf dem Markt befindlichen Diazo-Positiv-Trockenresist von 12 µm Dicke, zu dessen Kopie ca. 130 Sekunden und 1,5 Minuten Sprühentwicklung mit dem in Beispiel 2 genannten Entwickler nötig waren, brauchte dieser 70 µm dicke Resist nur ca. 60 Sekunden Belichtung bei einer Entwicklungszeit von ca. 3 Minuten. Wenn die Cu-Oberfläche, Laminierbedingungen, Trocknung, Belichtung und Entwicklung, innerhalb von 5-10 Minuten nach Belichtung, optimal aufeinander eingestellt sind, erhält man 70 µm tiefe Reliefs von hervorragender Kantenschärfe und -form, wobei Linien bis ca. 70 µm Linienbreite und -abstand gut wiedergegeben werden. Nach den üblichen Galvanoschritten wurde der Resist als Lötmaske benutzt, wofür er durch die Zusatzharze hitzebeständiger und haftfester wurde.

## Beispiel 13

Zur Beschichtung von Zinkplatten für die Herstellung von Hochdruck-Klischees wurden gelöst in

41 Gt Äthylenglykolmonoäthyläther,
28,5 Gt Novolak wie in Beispiel 1,
10 Gt Staybelite® Ester 5 (siehe Beispiel 5),
7,5 Gt Polyäthylacrylat niedrigviskos,
10,5 Gt Bis-(5-phenoxy-1,3-dioxan-2-yl)-äther des 2 Phenoxy-1,3-propandiols,
2,2 Gt des in Beispiel 8 angegebenen Triazins und
0,3 Gt Zaponechtviolett BE (C. I. 12196).

Durch kontinuierliches Umpumpen durch einen Gießerspalt wurde ein Flüssigkeitsvorhang dieser Beschichtungslösung erzeugt, durch den entfettete und durch Überspülen mit 0,5 %iger Salpetersäure chemisch aufgerauhte Zinkplatten durchgeschoben und dadurch beschichtet wurden. Nach dem Trocknen der durch Einstellen des Gießervorhangs und der Plattentransport-Geschwindigkeit auf ein Gewicht von 2,9 g/m² eingestellten Schicht wurde sie so erhaltene hochlichtempfindliche, lagerfähig vorbeschichtete Positiv-Zinkätzplatte unter einer positiven Vorlage einer Autotypie mit 44er Raster belichtet und entwickelt, wie es in der Chemigraphie üblich ist. Dazu wurde mit dem Entwickler von Beispiel 7 in einer Schale, Küvette oder einem Durchlaufgerät die belichtete Schicht angequollen und anschließend mechanism entfernt, im einfachsten Falle durch Überwischen mit einem Tampon. Nach dem Entfernen der belichteten Schichtteile durch die Entwicklung lag auf dem metallischweißen Zink ein violett-blaues Resistbild vor, das durch Ätzen mit Salpetersäure unter Zusatz von Flankenschutzmitteln in einer Einstufenätzmaschine zu einer Hochdruckplatte verarbeitet wurde. Nach etwa 5 Minuten war die dem Raster entsprechende günstigste Ätztiefe erreicht. Zur Tonwertkorrektur, insbesondere bei Mehrfarbätzen kann noch nachgeätzt werden. Das Klischee ist direkt zum Drucken vieler Bilder und zur Herstellung von Matern geeignet. Da die Resistschicht weiter lichtempfindlich ist, kann sie trotz der schon erfolgten Ätzung nochmals kopiert und geätzt werden. z. B. zum Einfügen einer negativen Schrift. Außerdem ist es möglich, die Zinkätzplatte bei Dicken unter 1,75 mm zu Rundformen zu biegen. Dies ist auch dann möglich, wenn die Schicht zur Erzeugung höherer Druckfestigkeit evtl. 5-15 Minuten 100-200 °C getempert werden soll. Infolge der zugesetzten Harze und ihrer Abmischung zeigt sie erhöhte Haftung, Flexibilität und Ätzfestigkeit unter diesen Bedingungen.

Beispiel 14

Eine 18 μm dicke Positiv-Trockenresistschicht folgender Zusammensetzung wurde auf eine 25 μm dicke Polyesterfolie beschichtet und mit einer Polyolefin-Folie kaschiert :

    54    Gt Novolak wie in Beispiel 1,
    21    Gt modifiziertes Terpenharz wie in Beispiel 11,
   8,5   Gt Polyvinyläthyläther,
    8    Gt polymerer Orthoester, hergestellt aus Orthoameisensäuretrimethylester und einem Gemisch von 2-Äthyl-5-methyl-2-hydroxymethyl-4-oxa-1,7-heptandiol und 2-Äthyl-2-hydroxymethyl-4-oxa-1,7-octandiol,
    8    Gt des Polyacetals aus Diäthylenglykoldivinyläther und Cyclohexan-1,4-diol,
 0,45  Gt des in Beispiel 12 angegebenen Triazins,
 0,05  Gt Kristallviolett-Base.

Damit wurden Keramik- bzw. Glas-Substrate durch Laminieren beschichtet, die für Mikrowellenschaltungen, Hybrid-Bauteile oder Displays meist im Format 10 cm × 10 cm verwendet werden und von folgender Art waren : Aluminiumoxid dünn beschichtet mit Metall ($Al_2O_3$/Al, $Al_2O_3$/Ti, $Al_2O_3$/Ti/Ni/Au), oder Glas/Cr, Glas/Ni, Glas/Sn-In-Oxid, Glas/Sn-In-Oxid/Cu.

Auf allen diesen Trägern hatte diese Schichtkombination gute Haftung beim Laminieren ohne Vorwärmen der Substrate, sie ergab saubere randscharfe Kopien und zeigte Resistenz gegen verschiedene Ätz- und Galvanoprozesse. Die Kopie und Ätzung von Kupfer sowohl mit Eisen-III-chlorid als auch mit Kupfer-II-chlorid-Ätzlösung kann mehrfach wiederholt werden. Selbst die Ätzung der leitfähigen transparenten Sn-In-Oxid-Schicht mit starker Salzsäure bei 60 °C übersteht diese Schicht, wonach überraschend noch eine Zweitkopie möglich ist.

## Patentansprüche

1. Positiv arbeitendes strahlungsempfindliches Gemisch aus

a) einer Verbindung mit mindestens einer durch Säure spaltbaren C—O—C-Bindung,
b) einer bei Bestrahlung eine starke Säure bildenden Verbindung,
c) einem in Wasser unlöslichen, in wäßrig-alkalischen Lösungen löslichen Bindemittel und
d) mindestens einem Harz mit anderem Löslichkeitsverhalten als das Bindemittel (c),

dadurch gekennzeichnet, daß das Harz mit anderem Löslichkeitsverhalten

d1) ein Polyurethanharz aus einem organischen Isocyanat und einem Hydroxygruppen enthaltenden Polymeren,
d2) ein Polyvinylalkyläther, ·
d3) ein Alkylacrylat-Polymerisat oder
d4) ein hydriertes oder teilhydriertes Kolophonium-Derivat

ist.

2. Strahlungsempfindliches Gemisch nach Anspruch 1, dadurch gekennzeichnet, daß es den Bestandteil d) in einer Menge von 1 bis 50 Gew.-%, bezogen auf die nichtflüchtigen Bestandteile des Gemischs, enthält.

3. Strahlungsempfindliches Gemisch nach Anspruch 1, dadurch gekennzeichnet, daß die durch Säure spaltbare Verbindung (a) ein Orthocarbonsäurederivat, ein Acetal, ein Enoläther oder ein N-Acyliminocarbonat ist.

4. Strahlungsempfindliches Gemisch nach Anspruch 1, dadurch gekennzeichnet, daß das Bindemittel (c) ein Novolak ist.

5. Verfahren zur Herstellung von Reliefbildern, bei dem man ein lichtempfindliches Material aus einer temporären Trägerfolie und einer lichtempfindlichen thermoplastischen Schicht unter Druck und Erwärmen auf ein Trägermaterial laminiert, die lichtempfindliche Schicht bildmäßig belichtet und nach dem Abziehen der temporären Trägerfolie die belichteten Schichtbereiche mit einer wäßrig-alkalischen Entwicklerlösung auswäscht, dadurch gekennzeichnet, daß die lichtempfindliche thermoplastische Schicht aus einem lichtempfindlichen Gemisch gemäß Anspruch 1 besteht.

# 0 042 562

**Claims**

1. A positive-working radiation-sensitive mixture composed of

a) a compound having at least one C—O—C bond which can be split by acid,
b) a compound which forms a strong acid when irradiated,
c) a binder which is insoluble in water and soluble in aqueous-alkaline solutions and
d) at least one resin, the solubility properties of which differ from those of the binder c)

characterized in that the resin having different solubility properties is

d1) a polyurethane resin obtained from an organic isocyanate and a polymer which contains hydroxyl groups,
d2) a polyvinyl alkyl ether,
d3) an alkyl acrylate polymer or
d4) a hydrogenated or partially hydrogenated derivative of colophony.

2. A radiation-sensitive mixture as claimed in claim 1, which contains the component d) in a quantity of 1 to 50 % by weight, relative to the non-volatile constituents of the mixture.

3. A radiation-sensitive mixture as claimed in claim 1, wherein the compound (a) which can be split by acid is an ortho-carboxylic acid derivative, an acetal, an enol ether or a N-acyliminocarbonate.

4. A radiation-sensitive mixture as claimed in claim 1, wherein the binder (c) is a novolak.

5. A process for the preparation of relief images, which comprises laminating a light-sensitive material, which is composed of a temporary support film and a light-sensitive thermoplastic layer, to a support material under the action of pressure and heat, imagewise exposing the light-sensitive layer and, after the temporary support film has been peeled off, washing out the exposed layer areas by means of an aqueous-alkaline developer solution, charcterized in that the light-sensitive thermoplastic layer comprises a light-sensitive mixture as claimed in claim 1.

**Revendications**

1. Mélange sensible au rayonnement, travaillant positivement, constitué de

a) un composé ayant au moins une liaison C—O—C pouvant être scindée par des acides,
b) un composé formant un acide fort par irradiation,
c) un liant insoluble dans l'eau, soluble dans les solutions aqueuses-alcalines et
d) au moins une résine ayant un autre comportement de solubilité que le liant c),

caractérisé en ce que la résine ayant un autre comportement de solubilité est

d1) une résine de polyuréthane préparée à partir d'un isocyanate organique et d'un polymère contenant des groupes hydroxy,
d2) un éther polyvinylalkylique,
d3) un polymère d'acrylate d'alkyle ou
d4) un dérivé hydrogéné ou partiellement hydrogéné de la colophane.

2. Mélange sensible au rayonnement suivant la revendication 1, caractérisé en ce qu'il contient le constituant d) dans une quantité de 1 à 50 % en poids par rapport aux constituants non volatils du mélange.

3. Mélange sensible au rayonnement suivant la revendication 1, caractérisé en ce que le composé (a) scindable par les acides est un dérivé d'acide orthocarboxylique, un acétal, un éther énolique ou un N-acyliminocarbonate.

4. Mélange sensible au rayonnement suivant la revendication 1, caractérisé en ce que le liant c) est une novolaque.

5. Procédé de préparation d'images en relief, dans lequel on stratifie une matière sensible à la lumière constituée d'une feuille de support temporaire et d'une couche thermoplastique sensible à la lumière, sous pression et en chauffant, sur une matière de support, on expose la couche sensible à lumière selon une image, et après avoir détaché la feuille de support temporaire, on élimine par lavage les régions exposées de la couche avec une solution aqueuse-alcaline de révélateur, caractérisé en ce que la couche thermoplastique sensible à la lumière se compose d'un mélange sensible à la lumière suivant la revendication 1.

13